# EUROPEAN PATENT APPLICATION

(11) **EP 2 849 535 A1**
(43) Date of publication of application: **18.03.2015**
(21) Application number: 13788231.2
(22) Date of filing: 01.05.2013
(51) Int. Cl.: H05B 33/04, H01L 51/50, H05B 33/02, H05B 33/10, H05B 33/22

(54) **ORGANIC EL LIGHT EMITTING DEVICE**

(30) Priority: 09.05.2012 JP 2012107847
(71) Applicant: Mitsubishi Chemical Corporation, Chiyoda-ku Tokyo 100-8251 (JP)
(72) Inventor: BANDO Yoshimasa, Yokohama-shi Kanagawa 227-8502 (JP); SAITOU Keiko, Yokohama-shi Kanagawa 227-8502 (JP); TAKAHASHI Atsushi, Yokohama-shi Kanagawa 227-8502 (JP)
(74) Representative: Vossius & Partner
(86) International application number: PCT/JP2013/062728
(87) International publication number: WO 2013/168660

(57) **Abstract**

The invention is an organic EL luminescent device comprising: a translucent substrate (1); a first electrode (2) formed on the translucent substrate (1); an organic functional layer (3) that at least contains a luminescent layer and is formed on the first electrode (2); a second electrode (4) formed on the organic functional layer (3); a sealing layer (5) formed so as to cover the first electrode (2), the second electrode (4) and the organic functional layer (3); and a protective layer (7) provided on the sealing layer (5), wherein a spacer resin layer (9) intervenes between the second electrode (4) and the sealing layer (5) and does not adhere to the second electrode (4).

## Description

### Technical Field

The present invention relates to an organic EL (electroluminescence) luminescent device. Particularly, it relates to an organic EL luminescent device suitable for performing a laser repair treatment.

### Background Art

An organic EL luminescent device usually comprises an organic EL element in which a translucent substrate composed of glass, a plastic or the like, an anode composed of a transparent electrode, an organic functional layer having a luminescent layer, and a cathode are laminated sequentially.

When the organic EL luminescent device is allowed to stand at a state that the organic functional layer and the cathode are exposed to the air, there occurs a phenomenon of enlarging a non-luminescent region just as if the luminescent region of the organic functional layer were contracted by moisture and oxygen in the air and, as a result, the organic EL element is deteriorated in some cases, so that it becomes necessary to provide a sealing structure for blocking moisture and oxygen. As the sealing structure, Patent Documents 1 and 2 propose a sealing where an adhesive is directly laminated on the electrode and a flat glass or a metal foil as a sealing layer is fixed through the adhesive. In Patent Document 1, a dehydrating agent composed of an alkaline earth metal such as Ca is disposed around the luminescent region of the organic EL element and is sealed with an epoxy resin and then sealing is performed by fixing thereon with a sealing member. In Patent Document 2, a range wider than the cathode of the organic EL element is sealed with a UV curable resin containing crystalline zeolite and a sealing substrate is adhered thereon, thereby sealing being achieved.

Incidentally, in the case where a foreign matter is attached to a forming region of the organic EL element during a process of forming the organic functional layer, the anode, the cathode, and the like of the organic EL luminescent device and a short-circuit occurs between the anode and the cathode, there is sometimes performed a laser repair in which the foreign matter is irradiated with a laser light to burn the short-circuited spot (e.g., Patent Document 3).

### Prior Art Documents

### Patent Documents

Patent Document 1: JP-A-2006-80094
Patent Document 2: JP-A-2010-55861
Patent Document 3: JP-A-2011-249021

### Summary of the Invention

### Problems that the Invention is to Solve

In the case where a treatment of burning the short-circuited spot by laser repair is carried out for an organic EL luminescent device in which sealing is performed by applying an adhesive directly on an organic EL element and fixing a sealing layer such as a metal foil through the adhesive, a cyclic non-luminescent region surrounding a scar of the laser repair is generated to result in inferior repair.

An object of the invention is to provide an organic EL luminescent device in which such inferior repair by the laser repair hardly occurs.

### Means for Solving the Problems

The organic EL luminescent device of the first embodiment is characterized by an organic EL luminescent device comprising: a translucent substrate, a first electrode formed on the translucent substrate, an organic functional layer that is formed on the first electrode and has at least a luminescent layer, a second electrode formed on the organic functional layer, a sealing layer containing a thermoplastic resin, the layer being formed so as to cover at least the first electrode, the second electrode and the organic functional layer, and a protective layer formed on the sealing layer, wherein a spacer resin layer intervenes in at least a part of the space between the second electrode and the sealing layer and an adhesive strength at the interface between the space resin layer and the second electrode is lowest among adhesive strengths at all interfaces present between the sealing layer and the translucent substrate.

The organic EL luminescent device of the second embodiment is characterized in that, in the first embodiment, the spacer resin layer and the second electrode are not adhered.

The organic EL luminescent device of the third embodiment is characterized in that, in the first or second embodiment, the sealing layer is formed by a heating treatment of the thermoplastic resin and the melting point of the spacer resin layer is a temperature for the heating treatment or more.

The organic EL luminescent device of the fourth embodiment is characterized in that, in any one embodiment of the first to third embodiments, the spacer resin layer intervenes in the whole space between the second electrode and the sealing layer. Advantage of the Invention

In the organic EL luminescent device of the invention, a spacer resin layer that is not adhered to the second electrode intervenes between the second electrode and the sealing layer. Thereby, a gas generated by the laser repair is made easily diffuse into the surroundings, so that it is surmised that generation of a structural defect caused by the gas is prevented and the inferior repair is prevented (including suppression).

Namely, in Patent Document 3, the organic EL device is sealed with a sealing member in which a sheet-shaped adhesive is pasted to a sealing glass substrate. Here, since the laser repair decomposes an organic substance in the organic EL luminescent device into a gaseous form by heat of the laser, it is considered that deformation of the sheet-shape adhesive is generated by the pressure of the generated gas when the laser repair is performed in the case where the sheet-shape adhesive is pasted to the sealing glass substrate. Owing to the deformation, it is considered that, for example, peeling and the like of an upper electrode and an organic layer in the organic EL luminescent device occur and thus a new defect is generated around the repaired spot.

Moreover, as another factor for the occurrence of the inferior repair, it is surmised that the sealing layer having increased flowability owing to accumulation of heat of the laser may participate. Namely, in the case where the sheet-shape adhesive is pasted to the sealing glass substrate, it is considered that the sealing layer having increased flowability owing to accumulation of heat of the laser pushes the remaining second electrode to the first electrode side via a portion from which an inferior part is removed by the laser repair, passage of an electric current is generated between the electrodes, and thus an inferior repair occurs.

On the other hand, according to the organic EL luminescent device of the invention, since the spacer resin layer intervenes between the second electrode and the sealing layer, the flow of the sealing layer can be suppressed, so that it is surmised that the inferior repair is fmally prevented (including suppression).

### Brief Description of the Drawings

[Fig. 1] (a) of Fig. 1 is a cross-sectional view showing one example of the organic EL luminescent device of the invention and (b) of Fig. 1 is a top view of the spacer resin layer.
[Fig. 2] (a) of Fig. 2 and (b) of Fig. 2 show one example of the organic EL luminescent device of the invention and the (a) of Fig. 2 is a top view and the (b) of Fig. 2 is a cross-sectional view.
[Fig. 3] (a) of Fig. 3 to (h) of Fig. 3 are top views showing spacer resin layers.
[Fig. 4] (a) of Fig. 4 to (h) of Fig. 4 are schematic views showing production steps of a back surface member of the organic EL luminescent device.
[Fig. 5] (a) of Fig. 5 is a top view of a laser-repaired spot, (b) of Fig. 5 is a microscopic picture of a vicinity of a repaired spot after laser repair in Example 3, (c) of Fig. 5 is a microscopic picture of the vicinity of a repaired spot after laser repair in Comparative Example 2, and (d) of Fig. 5 is a drawing showing the (c) of Fig. 5 schematically.
[Fig. 6] Fig. 6 is a cross-sectional view showing another example of the organic EL luminescent device of the invention.

### Mode for Carrying Out the Invention

The following will explain preferable embodiments of the organic EL luminescent device of the invention in detail with reference to drawings. Incidentally, in the explanation of the drawings, the same numeral or sign is attached to the same element and repeated explanation is omitted. Moreover, the cross sections of the organic EL luminescent device and the organic EL element are schematically shown with enlarging them in a thickness direction.

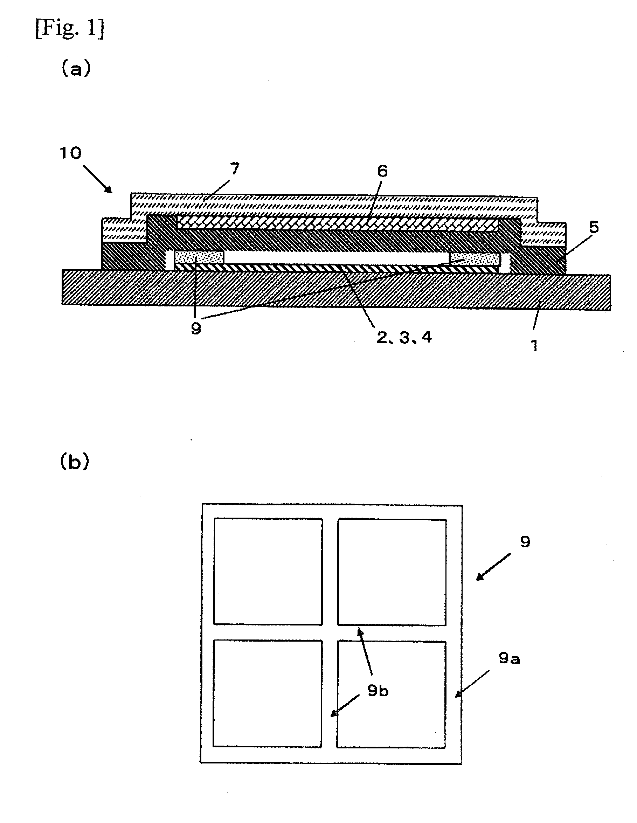

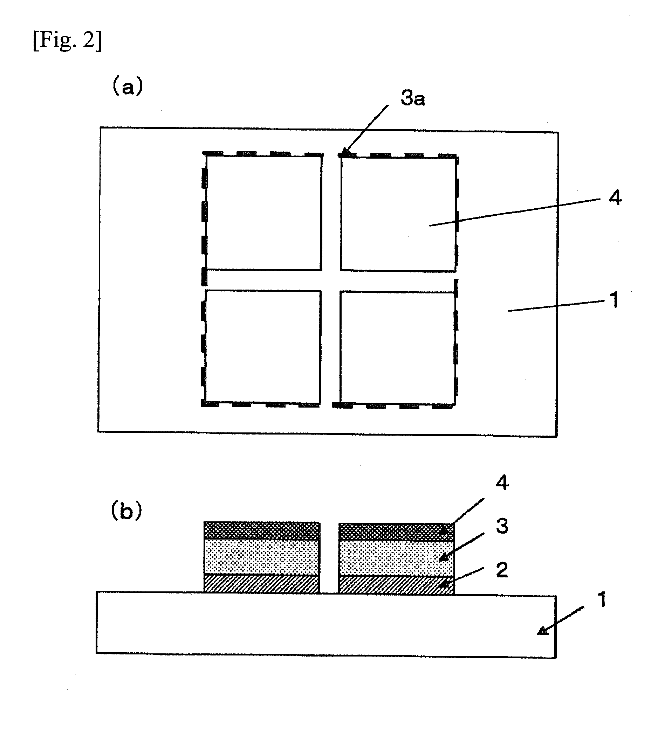

The (a) of Fig. 1 is a schematic outlined cross-sectional view showing one preferable embodiment of the organic EL luminescent device of the invention, the (b) of Fig. 1 is a top view of the spacer resin layer, the (a) of Fig. 2 is a top view of the organic EL element of the organic EL luminescent device of the invention, and the (b) of Fig. 2 is a cross-sectional view thereof. The organic EL luminescent device 10 shown in the (a) of Fig. 1 is comprised of an organic EL element (translucent substrate 1, first electrode 2, organic functional layer 3, and second electrode 4), a back surface member (sealing layer 5, moisture absorbing layer 6, and protective layer 7) formed on a back surface thereof, and a spacer resin layer 9 between the both. The following will describe the organic EL element, the back surface member, and the spacer rein layer in detail.

### [Organic EL Element]

As shown in the (a) of Fig. 2 and the (b) of Fig. 2, the organic EL element of the organic EL luminescent device 10 has a translucent substrate 1, a first electrode 2 formed on the translucent substrate 1, an organic functional layer 3 formed on the first electrode 2, and a second electrode 4 formed on the organic functional layer 3. A light generated by luminescence at the luminescent layer of the organic functional layer 3 is taken out through the translucent substrate 1.

The constitution of the organic EL element and constitutional materials thereof are not particularly limited but, as the constitutional materials, for example, the following ones may be mentioned.

### <Translucent Substrate>

The translucent substrate 1 is to be a support of the organic EL element and there can be used a sheet of quartz or glass, a metal sheet or a metal foil, a plastic film or sheet, or the like. In particular, preferred is a glass sheet or a sheet of a transparent synthetic resin such as polyester, polymethacrylate, polycarbonate, or polysulfone. In the case of using a substrate made of a synthetic resin, it is necessary to pay attention to a gas barrier property. When the gas barrier property of the translucent substrate 1 is high, deterioration of the organic EL element owing to the air permeated through the translucent substrate 1 hardly occurs. Therefore, a method of securing the gas barrier property by providing a dense silicon oxide film or the like on at least one side of the substrate made of a synthetic resin is also one of preferable methods. The thickness of the translucent substrate 1 is usually from 0.01 to 10 mm, preferably from 0.1 to 1 mm.

### <First Electrode>

The first electrode 2 is an anode and is an electrode that fulfills the role of hole injection into the organic functional layer 3. The anode is composed of a metal such as aluminum, gold, silver, nickel, palladium, or platinum, a metal oxide such as an oxide of a metal such as indium and/or tin, a metal halogenide such as copper iodide, or carbon black, or further a conductive polymer such as poly(3-methylthiophene), polypyrrole, or polyaniline, or the like.

The formation of the anode is usually performed by a dry method such as a sputtering method or a vacuum deposition method in many cases. In the case of forming the anode by using, for example, fine particles of a metal such as silver, fine particles of copper iodide or the like, carbon black, fine conductive metal oxide particles, a fine conductive polymer powder, or the like, the anode can be also formed by dispersing the material in an appropriate binder resin solution and applying the solution on the substrate. In the case of an electroconductive polymer, it is also possible to form a thin film directly on the substrate by electrolytic polymerization or to apply the electroconductive polymer on the substrate (see, Appl. Phys. Lett., Vol. 60, page 2711, 1992).

The thickness of the anode varies depending on the required transparency. In the case where transparency is required, the transmittance for a visible light is desirably set to usually 60% or more, preferably 80% or more. In this case, the thickness of the anode is usually 5 nm or more, preferably 10 nm or more, and, an upper limit thereof is usually 1,000 nm, preferably 500 nm. In the case where the anode may be opaque, the anode may have an arbitrary thickness and the anode may be the same as the substrate 1. The first electrode 2 usually has a single-layer structure but, if desired, can have a multilayer structure composed of plural materials.

### <Organic Functional Layer>

The organic functional layer 3 may be a single-layer structure or a multiplayer structure so far as it has at least a luminescent layer. Examples of the multiplayer structure include a three-layer structure composed of a hole injection and transport layer, a luminescent layer, and an electron injection layer, a five-layer structure composed of a hole injection layer, a hole transport layer, a luminescent layer, a hole blocking layer, and an electron injection layer, and the like. It is possible to perform appropriate selection.

### [Hole Injection Layer]

A layer carrying a function of transporting holes from the anode side to the luminescent layer side is usually called a hole injection and transport layer or a hole transport layer. In the case where two or more layers carrying a function of transporting holes from the anode side to the luminescent layer side are present, the layer near to the anode side is sometimes called a hole injection layer. The hole injection layer is preferably used in view of strengthening the function of transporting holes from the anode side to the luminescent layer side. In the case of using the hole injection layer, the hole injection layer is usually formed on the anode. The hole injection layer is not an essential layer in the organic EL element according to the invention but, in view of strengthening the function of transporting holes from the anode to the luminescent layer side, it is preferred to use the hole injection layer.

The film thickness of the hole injection layer 3 is usually 1 nm or more, preferably 5 nm or more and is usually 1,000 nm or less, preferably 500 nm or less. A method of forming the hole injection layer may be a vacuum deposition method or a wet film-forming method. In view of excellent in film-forming ability, it is preferred to form the layer by the wet film-forming method.

The hole injection layer preferably contains a hole transporting compound, more preferably the hole transporting compound and an electron accepting compound. Furthermore, the hole injection layer preferably contains a cation radical compound, particularly preferably contains the cation radical compound and the hole transporting compound.

### (Hole Transporting Compound)

A hole injection layer-forming composition usually contains a hole transporting compound to be a constituent of the hole injection layer. Moreover, in the case of the wet film-forming method, the composition usually further contains a solvent, too. The hole transporting compound is preferably a compound having high hole transporting property and being capable of efficiently transporting the injected holes. Accordingly, a compound having large hole mobility and hardly producing impurities to form a trap during the production or use is preferred. Also, a compound having excellent stability, small ionization potential, and high translucency to a visible light is preferred. Particularly, in the case where the hole injection layer comes into contact with the luminescent layer, a compound causing no quenching of luminescence from the luminescent layer or forming no exciplex with the luminescent layer to result in no decrease in the luminous efficiency.

In view of barrier to charge injection from the anode to the hole injection layer, the hole transporting compound is preferably a compound having an ionization potential of 4.5 eV to 6.0 eV. Examples of the hole transporting compound include an aromatic amine compound, a phthalocyanine compound, a porphyrin compound, an oligothiophene compound, a polythiophene compound, a benzylphenyl compound, a compound having tertiary amines connected through a fluorene group, a hydrazone compound, a silazane compound, a quinacridone compound, and the like.

Among the aforementioned exemplified compounds, in view of an amorphous property and transmittance for a visible light, an aromatic amine compound is preferred, and an aromatic tertiary amine compound is more preferred. The aromatic tertiary amine compound as used herein is a compound having an aromatic tertiary amine structure and includes also a compound having a group derived from an aromatic tertiary amine. The aromatic tertiary amine compound is not particularly limited in its kind, but in view of uniform luminescence thanks to a surface smoothing effect, it is preferred to use a polymer compound having a weight-average molecular weight of 1,000 to 1,000,000 (a polymerized compound where repeating units are connected). Preferred examples of the aromatic tertiary amine polymer compound include a polymer compound having a repeating unit represented by the following formula (I): 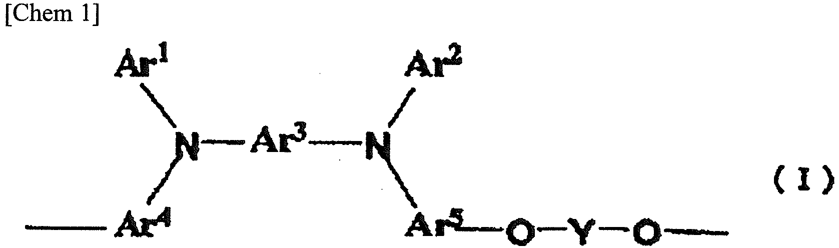 wherein each of Ar¹ and Ar² independently represents an aromatic hydrocarbon group which may have a substituent or an aromatic heterocyclic group which may have a substituent; each of Ar³ to Ar⁵ independently represents an aromatic hydrocarbon group which may have a substituent or an aromatic heterocyclic group which may have a substituent; Y represents a linking group selected from the following linking groups; and, among Ar¹ to Ar⁵, two groups bonded to the same nitrogen atom may combine with each other to form a ring.

### <Linking Groups>

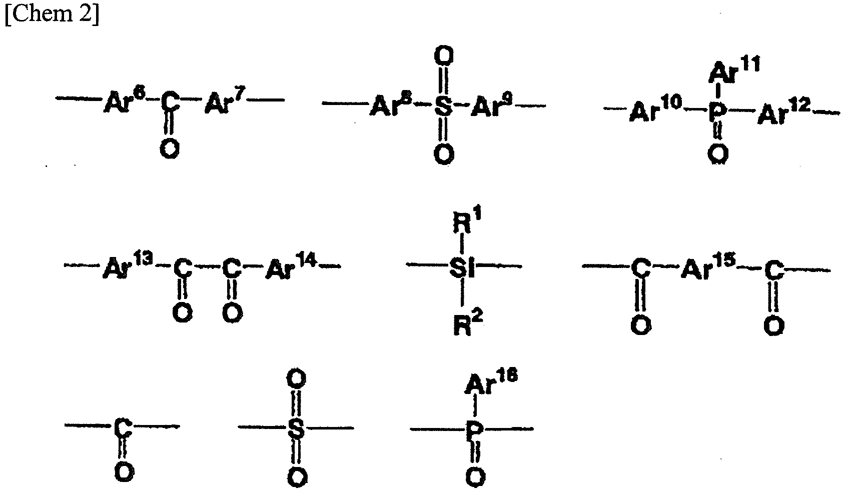

wherein each of Ar⁶ to Ar¹⁶ independently represents an aromatic hydrocarbon group which may have a substituent or an aromatic heterocyclic group which may have a substituent; and each of R¹ and R² independently represents a hydrogen atom or an arbitrary substituent.

In view of solubility, heat resistance and hole injection/transport property of the polymer compound, the aromatic hydrocarbon group or aromatic heterocyclic group for Ar¹ to Ar¹⁶ is preferably a group derived from a benzene ring, a naphthalene ring, a phenanthrene ring, a thiophene ring, or a pyridine ring, further preferably a group derived from a benzene ring or a naphthalene ring.

Specific examples of the aromatic tertiary amine polymer compound having a repeating unit represented by formula (I) include the compounds described in International Publication No. 2005/089024.

### (Electron Accepting Compound)

The hole injection layer preferably contains an electron accepting compound because the electroconductivity of the hole injection layer can be enhanced through oxidation of the hole transporting compound.

The electron accepting compound is preferably a compound having oxidizing power and having an ability to accept one electron from the aforementioned hole transporting compound. Specifically, a compound having an electron affinity of 4 eV or more is preferred, and a compound having an electron affinity of 5 eV or more is more preferred.

Such an electron accepting compound includes, for example, one kind or two or more kinds of compounds selected from the group consisting of a triarylboron compound, a metal halide, a Lewis acid, an organic acid, an onium salt, a salt of an arylamine with a metal halide, and a salt of an arylamine with a Lewis acid. Specifically, there may be mentioned an organic group-substituted onium salt such as triphenylsulfonium tetrafluoroborate; iron(III) chloride (JP-A-11-251067); a high-valence inorganic compound such as and ammonium peroxodisulfate; a cyano compound such as tetracyanoethylene; an aromatic boron compound such as tris(pentafluorophenyl)borane (JP-A-2003-31365); an ionic compound described in (International Publication No. 2005/089024); a fullerene derivative, iodine, and the like.

### (Cation Radical Compound)

As the cation radical compound, an ionic compound composed of a cation radical that is a chemical species in which one electron is removed from the hole transporting compound and a counter anion is preferred. However, in the case where the cation radical is derived from a hole transporting polymer compound, the cation radical has a structure in which one electron is removed from the repeating unit of the polymer compound.

As the cation radical, in view of an amorphous property, transmittance for a visible light, heat resistance, solubility, and the like, a chemical species in which one electron is removed from the aforementioned compound as a hole transporting compound is preferred.

Here, the cation radical compound can be formed by mixing the aforementioned hole transporting compound and the electron accepting compound. Namely, by mixing the aforementioned hole transporting compound and the electron accepting compound, electron transfer from the hole transporting compound to the electron accepting compound is caused to form a cation ionic compound composed of a cation radical of the hole transporting compound and a counter anion.

A cation radical compound derived from the polymer compound such as PEDOT/PSS (Adv. Mater., 2000, Vol. 12, page 481) and an emeraldine hydrochloride salt (J. Phys. Chem., 1990, Vol. 94, page 7716) is also formed by oxidative polymerization (dehydrogenative polymerization).

The oxidative polymerization as described herein means that a monomer is chemically or electrochemically oxidized in an acidic solution using a peroxodisulfate salt or the like. In the case of the oxidative polymerization (dehydrogenative polymerization), the monomer is oxidized into a polymer and simultaneously a cation radical in which one electron is removed from the repeating unit of the polymer is formed, an anion derived from the acidic solution being a counter anion.

### [Hole Transport Layer]

The hole transport layer is a layer performing a function of transporting holes from the anode side to the luminescent layer side. The hole transport layer is not an essential layer in the organic EL element according to the invention but, in view of strengthening the function of transporting holes from the anode to the luminescent layer side, it is preferred to use the layer. In the case of using the hole transport layer, the hole transport layer is usually formed between the anode and the luminescent layer. Moreover, in the case where the aforementioned hole injection layer is present, the hole transporting layer is provided between the hole transport layer is formed between the hole injection layer and the luminescent layer.

The film thickness of the hole transport layer is usually 5 nm or more, preferably 10 nm or more, and, on the other hand, is usually 300 nm or less, preferably 100 nm or less. A method for forming the hole transport layer may be a vacuum deposition method or a wet film-forming method. In view of an excellent film forming property, it is preferred to form the layer by the wet film-forming method.

The hole transport layer usually contains a hole transporting compound to be a constituent of the hole transport layer. As the hole transporting compound to be contained in the hole transport layer, there may be mentioned an aromatic diamine containing two or more tertiary amines, in which two or more fused aromatic rings are substituted on the nitrogen atom, typified by 4,4'-bis[N-(1-naphthyl)-N-phenylamino]biphenyl (JP-A-5-234681); an aromatic amine compound having a starburst structure, such as 4,4',4"-tris(1-naphthylphenylamino)triphenylamine (J. Lumin., Vol. 72-74, page 985, 1997); an aromatic amine compound composed of a tetramer of triphenylamine (Chem. Commun., page 2175, 1996); a spiro compound such as 2,2',7,7'-tetrakis-(diphenylamino)-9,9'-spirobifluorene (Synth. Metals, Vol. 91, page 209, 1997); a carbazole derivative such as 4,4'-N,N'-dicarbazolebiphenyl; and the like. Moreover, for example, polyvinylcarbazole, a polyvinyltriphenylamine (JP-A-7-53953), or a polyarylene ether sulfone containing tetraphenylbenzidine (Polym. Adv. Tech., Vol. 7. page 33, 1996) can be also preferably used.

### [Luminescent Layer]

The luminescent layer is a layer that performs a function of being excited and emitting a light through recombination of a hole injected from the anode and an electron injected from the cathode when an electric field is applied between one pair of electrodes. The luminescent layer is a layer formed between the anode and the cathode. Usually, in the case where the hole injection layer is present on the anode, the luminescent layer is formed between the hole injection layer and the cathode and, in the case where the hole transport layer is present on the anode, the luminescent layer is formed between the hole transport layer and the cathode.

The film thickness of the emitting layer may be arbitrarily selected unless the advantages of the invention are seriously impaired. The film thickness is preferably large in view that a defect is scarcely produced in the film, but on the other hand, the film thickness is preferably small from the standpoint that the driving voltage is liable to be reduced. Therefore, the film thickness is usually 3 nm or more, preferably 5 nm or more, and, on the other hand, is usually 200 nm or less, preferably 100 nm or less.

The luminescent layer contains a material having a luminescent property (luminescent material) and also preferably a material having a charge transporting property (charge transporting material).

### (Luminescent Material)

The luminescent material is not particularly limited as long as it emits a light having a desired emission wavelength and does not impair the advantages of the invention and an arbitrary known material can be applied. The luminescent material may be a fluorescent material or a phosphorescent material but is preferably a material having good luminous efficiency and, in view of inner quantum efficiency, the luminescent material is preferably a phosphorescent material.

Examples of the fluorescent material include the following materials.

Examples of the fluorescent material giving blue luminescence (blue fluorescent material) include naphthalene, perylene, pyrene, anthracene, coumarin, chrysene, p-bis(2-phenylethenyl)benzene, derivatives thereof, and the like.

Examples of the fluorescent material giving green luminescence (green fluorescent material) include a quinacridone derivative, a coumarin derivative, an aluminum complex such as Al(C₉H₆NO)₃, and the like.

Examples of the fluorescent material giving yellow luminescence (yellow fluorescent material) include rubrene, a perimidone derivative, and the like.

Examples of the fluorescent material giving red luminescence (red fluorescent material) include a DCM (4-(dicyanomethylene)-2-methyl-6-(p-dimethylaminostyryl)-4H-pyran)-based compound, a benzopyran derivative, a rhodamine derivative, a benzothioxanthene derivative, azabenzothioxanthene, and the like.

Moreover, examples of the phosphorescent material include organometallic complexes each containing a metal selected from Groups 7 to 11 of the long period-type periodic table (hereinafter, unless otherwise specified, the "periodic table" indicates the long period-type periodic table) and the like. As the metal selected from Groups 7 to 11 of the periodic table, there may be preferably mentioned ruthenium, rhodium, palladium, silver, rhenium, osmium, iridium, platinum, gold, and the like.

The ligand of the organometallic complex is preferably a ligand in which a (hetero)aryl group is coupled with pyridine, pyrazole, phenanthroline, or the like, such as a (hetero)arylpyridine ligand and a (hetero)arylpyrazole ligand. In particular, a phenylpyridine ligand and a phenylpyrazole ligand are preferred. The (hetero)aryl as described herein indicates an aryl group (aromatic hydrocarbon group) or a heteroaryl group (aromatic heterocyclic group).

Specific examples of preferable phosphorescent materials include phenyl pyridine complexes such as tris(2-phenylpyridine)iridium, tris(2-phenylpyridine)ruthenium, tris(2-phenylpyridine)palladium, bis(2-phenylpyridine)platinum, tris(2-phenylpyridine)osmium, and tris(2-phenylpyridine)rhenium; porphyrin complexes such as octaethyl platinum porphyrin, octaphenyl platinum porphyrin, octaethyl palladium porphyrin, and octaphenyl palladium porphyrin; and the like.

As the polymeric luminescent material, there may be mentioned polyfluorene-based materials such as poly(9,9-dioctylfluoren-2,7-diyl), poly[(9,9-dioctylfluoren-2,7-diyl)-co-(4,4'-(N-(4-sec-butylphenyl))diphenylamine)], and poly[(9,9-dioctylfluoren-2,7-diyl)-co-(1,4-benzo-2{2,1'-3}-triazole)]; polyphenylenevinylene-based materials such as poly[2-methoxy-5-(2-hethylhexyloxy)-1,4-phenylenevinylene]; and the like.

### (Charge Transporting Material)

The charge transporting material is a material having a positive charge (hole) or a negative charge (electron) and is not particularly limited unless it impairs the advantages of the invention, and known luminous materials can be applied.

As the charge transporting material, compounds that have been conventionally used in the luminescent layer of an organic EL element can be used. Particularly, preferred is a compound that is conventionally used as a host material of a luminescent layer.

As the charge transporting material, there may be specifically mentioned compounds exemplified as hole transporting compounds of the hole injection layer, such as an aromatic amine compound, a phthalocyanine compound, a porphyrin compound, an oligothiophene compound, a polythiophene compound, a benzylphenyl compound, a compound having tertiary amines connected through a fluorene group, a hydrazone compound, a silazane compound, a silanamine compound, a phosphamine compound, a quinacridone compound, and the like. In addition, there may be mentioned an electron transporting compound such as an anthracene compound, a pyrene compound, a carbazole compound, a pyridine compound, a phenanthroline compound, an oxadiazole compound, a silole compound, and the like.

Moreover, for example, there can be preferably used a compound exemplified as a hole transporting compound of the hole transport layer, such as an aromatic diamine containing two or more tertiary amines, in which two or more fused aromatic rings are substituted on the nitrogen atom, typified by 4,4'-bis[N-(1-naphthyl)-N-phenylamino]biphenyl (JP-A-5-234681); an aromatic amine compound having a starburst structure, such as 4,4',4"-tris(1-naphthylphenylamino)triphenylamine (J. Lumin., Vol. 72-74, page 985, 1997); an aromatic amine compound composed of a tetramer of triphenylamine (Chem. Commun., page 2175, 1996); and a spiro compound such as 2,2',7,7'-tetrakis-(diphenylamino)-9,9'-spirobifluorene (Synth. Metals, Vol. 91, page 209, 1997); a carbazole derivative such as 4,4'-N,N'-dicarbazolebiphenyl; and the like. Moreover, besides, there may be also mentioned an oxadiazole compound such as 2-(4-biphenylyl)-5-(p-tertiary-butylphenyl)-1,3,4-oxadiazole (tBu-PBD) or 2,5-bis(1-naphthyl)-1,3,4-oxadiazole (BND); a silole compound such as 2,5-bis(6'-(2',2"-bipyridyl))-1,1-dimethyl-3,4-diphenylsilole (PyPySPyPy); a phenanthroline compound such as bathophenanthroline (BPhen) or 2,9-dimethyl-4,7-diphenyl-1,10-phenanthroline (BCP, bathocuproine); and the like.

### [Hole Blocking Layer]

A hole blocking layer may be provided between the luminescent layer and the cathode. The hole blocking layer is a layer usually laminated on the luminescent layer so as to come into contact with the interface on the cathode side of the luminescent layer.

The hole blocking layer has a role of blocking holes moving from the cathode to reach the anode and a role of efficiently transporting electrons injected from the cathode toward the luminescent layer. Physical properties required of the material constituting the hole blocking layer include high electron mobility, low hole mobility, a large energy gap (difference between HOMO and LUMO), a high excited triplet level (T1), and the like.

Examples of a material of the hole blocking layer satisfying such conditions include a mixed ligand complex such as bis(2-methyl-8-quinolinolato)(phenolato)aluminum and bis(2-methyl-8-quinolinolato)(triphenylsilanolato)aluminum; a metal complex such as bis(2-methyl-8-quinolate)aluminum-µ-oxo-bis-(2-methyl-8-quinolinolato)aluminum binuclear metal complex; a styryl compound such as a distyrylbiphenyl derivative (JP-A-11-242996), a triazole derivative such as 3-(4-biphenylyl)-4-phenyl-5-(4-tert-butylphenyl)-1,2,4-triazole (JP-A-7-41759); a phenanthroline derivative such as bathocuproine (JP-A-10-79297); and the like. Furthermore, a compound having at least one pyridine ring substituted at 2-, 4- and 6-positions described in International Publication No. 2005/022962 is also preferred as the material of the hole blocking layer.

A method for forming the hole blocking layer is not limited. Accordingly, the layer can be formed by a wet film-forming method, a vapor deposition method or the other methods. The film thickness of the hole blocking layer may be arbitrarily selected unless the advantages of the present invention are seriously impaired. The film thickness is usually 0.3 nm or more, preferably 0.5 nm or more, and is usually 100 nm or less, preferably 50 nm or less.

### [Electron Transport Layer]

An electron transport layer may be provided between the luminescent layer and the cathode for the purpose of further enhancing the current efficiency of the element.

The electron transport layer is formed of a compound capable of efficiently transporting an electron injected from the cathode toward the luminescent layer direction between the electrodes to which an electric field is applied. As the electron transporting compound to be used for the electron transport layer, usually, preferred is a compound having high electron injection efficiency from the cathode or the electron injection layer and high electron mobility and being capable of efficiently transporting the injected electron. Specific examples of the electron transporting compound include a metal complex such as an aluminum complex of 8-hydroxyquinoline (JP-A-59-194393), a metal complex of 10-hydroxybenzo[h]quinoline, an oxadiazole derivative, a distyrylbiphenyl derivative, a silole derivative, a 3-hydroxyflavone metal complex, a 5-hydroxyflavone metal complex, a benzoxazole metal complex, a benzothiazole metal complex, trisbenzimidazolylbenzene (U.S. Patent No. 5645948), a quinoxaline compound (JP-A-6-207169), a phenanthroline derivative (JP-A-5-331459), 2-tert-butyl-9,10-N,N'-dicyanoanthraquinonediimine, n-type hydrogenated amorphous silicon carbide, n-type zinc sulfide, n-type zinc selenide, and the like.

The film thickness of the electron transport layer is usually 1 nm or more, preferably 5 nm or more, and, on the other hand, is usually 300 nm or less, preferably 100 nm or less.

The electron transport layer is formed by a wet film-forming method or a vapor deposition method on the cathode side of the hole blocking layer in the case where the hole blocking layer is present. Usually, a vapor deposition method is used.

### [Electron Injection Layer]

The electron injection layer may be provided on the luminescent layer side of the cathode for the purpose of efficiently injecting an electron from the cathode into the luminescent layer side. In the case of providing the electron injection layer, it is usually provided between the electron transport layer and the cathode.

In order to efficiently perform the electron injection, a material forming the electron injection layer is preferably a metal having a low work function. As examples thereof, there may be used an alkali metal such as sodium or cesium, and an alkaline earth metal such as barium or calcium, or a halide, an oxide, or other salt thereof. In the case where these materials are used as materials forming the electron injection layer, the film thickness of the electron injection layer is preferably 0.1 nm or more and 5 nm or less.

Moreover, it is also preferred to dope an organic electron transport compound typified by a nitrogen-containing heterocyclic compound such as bathophenanthroline or a metal complex such as an aluminum complex of 8-hydroxyquinoline with an alkali metal such as sodium, potassium, cesium, lithium, or rubidium (described, for example, in JP-A-10-270171, JP-A-2002-100478, and JP-A-2002-100482), because both of enhanced electron injection/transport performance and excellent film quality can be achieved. In this case, the film thickness is usually 5 nm or more, preferably 10 nm or more, and is usually 200 nm or less, preferably 100 nm or less.

The electron injection layer is formed by a wet film-forming method or a vapor deposition method.

### <Second Electrode>

The second electrode 4 is a cathode and is an electrode that fulfills the role of injecting an electron into the organic functional layer 3. For the cathode, materials the same as those used for the anode can be used. However, in order to efficiently perform the electron injection, the material of the cathode is preferably a metal having a low work function. For example, an appropriate metal such as tin, magnesium, indium, calcium, aluminum, and silver or an alloy thereof is used. Specific examples thereof include an alloy electrode having a low work function, such as magnesium-silver alloy, magnesium-indium alloy, and aluminum-lithium alloy. Incidentally, as the material of the cathode, only one kind of the material may be used, or two or more kinds of the materials may be used in arbitrary combination at an arbitrary ratio. The thickness of the cathode is usually the same as that of the anode.

### [Back Surface Member]

The back surface member of the organic EL luminescent device 10 shown in the (a) of Fig. 1 comprises a sealing layer 5, a moisture absorbing layer 6, and a protective layer 7. The moisture absorbing layer 6 is not an essential layer in the invention but, in view of deterioration suppression of the organic functional layer 3 by moisture, is preferably provided between the sealing layer 5 and the protective layer 7. The sealing layer 5 is a layer to be formed so as to cover the first electrode 2, the second electrode 4, and the organic functional layer 3 on the translucent substrate 1, which constitute an organic EL element. The sealing layer 5 preferably has a region that comes into contact with the surface of the second electrode 4 because of an excellent heat radiation property. On the sealing layer 5, the protective layer 7 is formed. Here, the protective layer 7 is preferably formed so as to cover the region where the organic functional layer 3 is formed. Moreover, in the case of providing the moisture absorbing layer 6, the layer is preferably formed so as to cover the region where the organic functional layer 3 is formed.

### <Sealing Layer>

The sealing layer 5 contains a thermoplastic resin having a pressure-sensitive adhesive property. The thermoplastic resin contained in the sealing layer 5 is not particularly limited but, for example, there may be mentioned polyethylene, polyisobutylene, polyisoprene, and the like. These may be used singly or two or more kinds of components may be used in arbitrary combination at an arbitrary ratio. Of these, from the standpoint of low moisture permeability, polyethylene and polybutylene are preferred. Moreover, the melting point of the thermoplastic resin is usually -80°C or more, preferably -20°C or more from the standpoint of heat resistance and an upper limit thereof is not particularly limited but is usually 80°C or less.

The sealing layer 5 may contain components other than the thermoplastic resin and, for example, a petroleum resin, a cyclic olefin polymer, and the like may be mentioned. Examples of the petroleum resin include C5 petroleum resins, C9 petroleum resins, C5C9 copolymerized petroleum resins, and the like described at page 1192 of "14906 no Kagaku Shohin" (published by The Chemical Daily Co., Ltd, 2006).

Specifically, the cyclic olefin polymer includes hydrogenated terpene resins (e.g., Clearon P, M, K series manufactured by Yasuhara Chemical Co., Ltd.), hydrogenated rosin and hydrogenated rosin ester resins (e.g., Foral AX, Foral 1105, Pensel A, Ester Gum H, Super Ester A series, etc.), disproportionated rosin and disproportionated rosin ester resins (e.g., Pine Crystal series manufactured by Arakawa Chemical Industries Ltd., etc.), hydrogenated dicyclopentadiene resins that are water-added resins of C5 petroleum resins obtained by copolymerization of C5 fractions such as pentene, isoprene, piperylene, 1,3-pentadiene, and the like that are formed by thermal cracking of petroleum naphtha (e.g., Escorez 5300, 5400 series, Eastotac H series manufactured by Exxon Mobil Corporation, etc.), partially hydrogenated aromatic modified dicyclopentadiene resins (e.g., Escorez 5600 series manufactured by Exxon Mobil Corporation, etc.), resins obtained by hydrogenating C9 petroleum resins obtained by copolymerization of C9 fractions such as indene, vinyltoluene, and α- or β-methylstyrene which are formed by thermal cracking of petroleum naphtha (e.g., Alcone P or M series manufactured by Arakawa Chemical Industries Ltd.), resins obtained by hydrogenation of the copolymerized petroleum resins of above-described C5 fractions and C9 fractions (e.g., IMARV series manufactured by Idemitsu Kosan Co., Ltd.), and the like.

To the thermoplastic resin, for example, a filler, a UV absorber, a UV stabilizer, an antioxidant, a resin stabilizer, and the like may be appropriately added within the range where the pressure-sensitive adhesive property and the like are not inhibited.

The thickness of the sealing layer 5 is preferably thick in view of absorbing outer impact but is preferably thin in view of suppressing moisture permeation. Specifically, the thickness of the sealing layer 5 is usually 1 µm or more, preferably 5 µm or more, more preferably 10 µm or more and, on the other hand, is usually 200 µm or less, preferably 100 µm or less, more preferably 50 µm or less.

### <Moisture Absorbing Layer>

The moisture absorbing layer 6 preferably contains a desiccant. The desiccant is not particularly limited as long as it is highly hygroscopic. Examples thereof include alkaline earth metals, alkali metals or oxides thereof, inorganic porous materials, and the like. These may be used singly or two or more kinds thereof may be used in combination. Of these, from the standpoints of moisture absorbing property and safety in handling, oxides of alkaline earth metals or alkali metals or inorganic porous materials are preferred and calcium oxide and zeolite are particularly preferred. The moisture absorbing layer 6 may contain components other than the desiccant and examples of the components include particles, rods, and the like composed of highly thermoconductive Si, AlN, or C.

In the case of forming the moisture absorbing layer 6, the layer is preferably formed between the second electrode 4 and the sealing layer 5, in the sealing layer 5, or between the sealing layer 5 and the protective layer 7. The moisture absorbing layer 6 is preferably formed between the sealing layer 5 and the protective layer 7 in view of preventing deterioration owing to moisture permeating through the protective layer 7 and is more preferably formed so as to come into contact with the protective layer.

The planar shape of the moisture absorbing layer 6 is not particularly limited as long as the layer can absorb moisture permeated from the outside and can be appropriately selected from a square, a rectangle, a circle, an ellipse, various cyclic shapes, and the like depending on the alignment of luminescent region of the luminescent layer.

The thickness of the moisture absorbing layer 6 is preferably thick in view of absorbing moisture but is preferably thin in view of heat radiation. Specifically, the thickness of the moisture absorbing layer 6 is usually 0.1 µm or more, preferably 1 µm or more, more preferably 10 µm or more and, on the other hand, is usually 500 µm or less, preferably 200 µm or less, more preferably 100 µm or less.

### <Protective Layer>

The protective layer 7 is a layer that cuts off moisture and oxygen from the outside and also functions as a support in the production of the back surface member.

The protective layer 7 is preferably flexible. When the protective layer 7 is flexible, weight saving and film thinning become possible and also cost reduction can be realized. Moreover, in the case where the sealing layer 5 is composed of a thermoplastic resin, the substrate can be recycled by melting and removing the thermoplastic resin of the sealing layer 5 in the case where the organic EL element is deteriorated.

As the protective layer 7, a metal foil or a laminate of a plastic film and an inorganic compound layer can be usually used. The protective layer 7 preferably has a gas barrier property. Examples of a metal having a gas barrier property include aluminum, copper, nickel and an alloy materials such as stainless steel and an aluminum alloy, and the like. Moreover, the laminate of a plastic film and an inorganic compound layer includes, for example, laminate films obtained by laminating one layer or multi layers of an inorganic oxide such as silicon oxide or aluminum oxide or an inorganic nitride such as silicon nitride or aluminum nitride on a plastic film. Of these, from the standpoints of processing and cost reduction, the protective layer 7 is preferably an aluminum foil.

The thickness of the protective layer 7 is preferably thick in view of the cut-off property of moisture and oxygen from the outside and strength as a support but is preferably thin in view of weight saving and film thinning. Specifically, the thickness of the protective layer 7 is usually 1 µm or more, preferably 10 µm or more, more preferably 40 µm or more and, on the other hand, is usually 500 µm or less, preferably 200 µm or less, more preferably 100 µm or less.

### <Spacer Resin Layer>

The spacer resin layer 9 intervenes in at least a part of the space between the second electrode 4 and the sealing layer 5 and is formed in contact with the second electrode 4. Here, the adhesive strength at the interface between the spacer resin 9 and the second electrode 4 is lowest among adhesive strengths of all interfaces present between the sealing layer 5 and the translucent substrate 1. This means the following state.

Namely, in the organic EL luminescent device comprising the spacer resin layer 9 of the invention, in the case where a step of peeling the sealing layer 5 from the translucent substrate 1 is conducted, the state is a state that peeling occurs not at the interfaces present from the translucent substrate 1 to the second electrode 4 (i.e., the interface between the translucent substrate 1 and the first electrode 2, the interface between the second electrode 2 and the organic functional layer 3, the interface between different layers in the organic functional layer 3, and the interface between the organic functional layer 3 and the second electrode 4) but at the interface between the spacer resin layer 9 and the second electrode 4. Here, the peeling step may be conducted using a conventionally known peeling testing machine but it is most convenient to conduct it by a human hand. For example, after a part of the sealing layer 5 at an edge part is lifted by inserting a sharp tool between the translucent substrate 1 and the sealing layer 5 in the edge part of the organic EL luminescent device, the part of the sealing layer 5 is grasped and the whole sealing layer 5 may be peeled from the translucent substrate 1.

In the invention, the reason why it is necessary to be in the above state is as follows.

First, when it is studied what phenomenon occurs in the vicinity of the laser repair-performed spot in the case where the spacer resin layer 9 is absent, it is considered that the organic functional layer material is vaporized by the laser irradiation to generate a gas. The volume of the generated gas increases as compared with the volume of the solid part vaporized, so that a void is generated around the laser irradiation spot. On this occasion, when the sealing layer 5 has strongly adhered to the second electrode 4, the above void may be generated not at the interface between the sealing layer 5 and the second electrode 4 but at any interface of the interface between the translucent substrate 1 and the first electrode 2, the interface between the first electrode 2 and the organic functional layer 3, the interface between different layers in the organic functional layer 3, and the interface between the organic functional layer 3 and the second electrode 4. Accordingly, it is surmised that a structural defect of the organic functional layer 3 is generated to cause the generation of non-luminescent region, thus resulting in inferior repair.

On the other hand, in the case where the spacer resin layer 9 is present and the adhesive strength at the interface between the spacer resin 9 and the second electrode 4 is lowest among adhesive strengths of all interfaces present between the sealing layer 5 and the translucent substrate 1, the void caused by the gas is formed at the most peelable interface between the spacer resin layer 9 and the second electrode 4. Therefore, no structural defect is generated in the organic functional layer 3 and also no inferior repair occurs.

Here, the spacer resin layer 9 is preferably not adhered to the second electrode 4. Here, the phrase "not adhered" means a state that, when a laminate in which a different layer is laminated on a certain layer is turned upside down, the upper layer is peeled from the lower layer by gravity. Specifically, for example, in the case where a resin sheet is overlaid on a metal sheet (in a state that an adhesive layer is absent between them) and the resin plate falls when the laminate is turned upside down, the state is said to be not adhered.

Namely, when the spacer resin layer 9 does not have any pressure-sensitive adhesive property and is not adhered to the second electrode, the void generated by the laser repair should be surely generated at the interface between the spacer resin layer 9 and the second electrode 4. Even when the spacer resin layer 9 has somewhat a pressure-sensitive adhesive property, the adhesive strength at the interface between the spacer resin 9 and the second electrode 4 is lowest among adhesive strengths of all interfaces present between the sealing layer 5 and the translucent substrate 1, it seemed that there arises a very high possibility that the void to be generated by the laser repair is generated at the interface between the spacer resin layer 9 and the second electrode 4.

In the case where the sealing layer 5 is formed by a heating treatment of the thermoplastic resin as mentioned later, the melting point of the resin that forms the spacer resin layer 9 is preferably the heat treatment temperature or more because the spacer resin layer 9 hardly attaches to the second electrode 4 in the heating treatment. Specifically, the melting point of the resin that forms the spacer resin layer 9 is preferably 10°C or more higher than the heating treatment temperature, further preferably 30°C or more higher than the temperature. An upper limit is not particularly limited but, from the standpoint of easiness of molding the spacer resin layer 9, a difference between the "melting temperature of the resin that forms the spacer resin layer 9" and the "heating treatment temperature" is preferably 200°C or less, further preferably 300°C or less.

As the resin constituting the spacer resin layer 9, PET (polyethylene terephthalate), PBT (polybutylene terephthalate), PEN (polyethylene naphthalate), PP (polypropylene), TEFLON (registered trademark), PTFE (polytetrafluoroethylene), PFA (tetrafluoroethylene-perfluoroalkyl vinyl ether copolymer), ETFE (tetrafluoroethylene-ethylene copolymer), cellulose, polyvinyl chloride, polyimides, polyamides, polycarbonate, silicon resins, acrylic resins, polystyrene, Nylon, polymethacrylate, polysulfone, and the like are suitable. Owing to high melting point and easy availability at a low cost, particularly, PET, PP, and polyimides are suitable.

The thickness of the spacer resin layer 9 is preferably thick in view of workability but is preferably thin in view of flexibility and weight saving and film thinning of a panel. Specifically, the thickness of the spacer resin layer 9 is usually 1 µm or more, preferably 10 µm or more, more preferably 15 µm or more and, on the other hand, is usually 150 µm or less, preferably 100 µm or less, more preferably 80 µm or less.

The spacer resin layer 9 preferably intervenes between the second electrode 4 and the sealing layer 5 as a film from the standpoint of production efficiency. As described in the sealing step to be mentioned later, the spacer resin layer 9 is preferably overlaid on the organic EL element after integration with the back surface member, from the standpoint of workability.

The spacer resin layer 9 may intervene in the whole space between the second electrode 4 and the sealing layer 5 as in the case of the spacer resin layer 9' shown in Fig.

6 or may intervene in only a part thereof. In the case where the layer intervenes in only a part thereof, the layer may be in a shape having a frame part constituting a peripheral part of the region between the second electrode 4 and the sealing 5 and a transverse part crossing the region. The (b) of Fig. 1 is a top view showing one example of such a spacer resin layer. The spacer resin layer 9 has a " 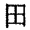 "-character shape having a frame part 9a and a cruciform transverse part 9b. However, the layer may have a " 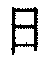 "-character shape in which the transverse part 9b is provided in only one direction or a " 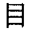 "-character shape or an about ladder shape in which a large number of the transverse parts are provided, or the layer may have a grid-shape in which plural transverse parts are provided lengthwise and crosswise.

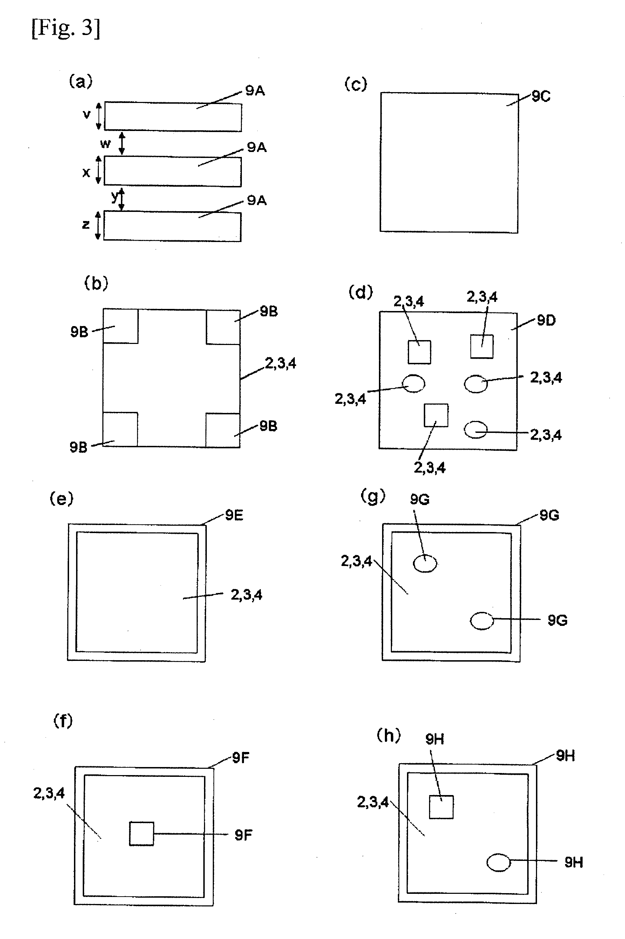

The spacer resin layer 9 may be a stripe-shape spacer resin layer 9A composed of plural parallel strips as shown in the (a) of Fig. 3 or a spacer resin layer 9B which is disposed at a corner part around the luminescent region as shown in (b) of Fig. 3. Moreover, the layer may be a planar spacer resin layer 9C as shown in (c) of Fig. 3 or may be a spacer resin layer 9D having a circular or square opening on the plane as shown in (d) of Fig. 3. Besides, as shown in (e) of Fig. 3, it may be a spacer resin layer 9E provided in a " 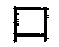 "-character shape at the outer peripheral part of the luminescent region, or spacer resin layers 9F to 9H composed of the " 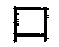 "-character shape and square(s), circle(s), and the like provided inside thereof as shown in (f) of Fig. 3 to the (h) of Fig. 3.

As above, the invention is described in detail based on embodiments thereof but the invention is not limited to the embodiments. The invention can be variously modified within the range without departing from the gist thereof. For example, in the present embodiments, there is described an organic EL element in which the first electrode 2, the organic functional layer 3 and the second electrode 4 are successively laminated on the translucent substrate 1. However, there may be formed an organic EL element in which the second electrode 4, the organic functional layer 3, and the first electrode (anode) 2 are successively laminated.

Next, the process for producing the organic EL element of the invention will be described. The process for producing the organic EL element of the invention usually comprises an element formation step, a back surface member formation step, and a heating treatment step. The following will describe each step.

### [Element Formation Step]

The element formation step is a step of forming the organic EL element. It is possible to adopt various methods but, for example, the step can be carried out by the following method.

First, the first electrode 2 is formed on the surface of the translucent substrate 1. The formation of the first electrode 2 can be usually performed by a sputtering method, a vacuum deposition method, or the like. Moreover, in the case of forming the first electrode 2 using fine particles of a metal such as silver, fine particles of copper iodide or the like, carbon black, electroconductive metal oxide fine particles, electroconductive polymer fine particles, or the like, the first electrode 2 can be also formed by dispersing a material to be the first electrode 2 in an appropriate binder resin solution and applying the dispersion on the translucent substrate 1. Furthermore, in the case of an electroconductive polymer, the first electrode 2 can be also formed by directly forming a thin film on the translucent substrate 1 by electrolytic polymerization or applying the electroconductive polymer on the translucent substrate 1 (Appl. Phys. Lett., Vol. 60, page 2711, 1992).

Next, on the first electrode 2, the organic functional layer 3 having at least a luminescent layer is formed. The method for forming the organic functional layer 3 can be appropriately selected depending on materials. For example, a vacuum deposition method, a spin coating method, a dip coating method, a die coating method, a bar coating method, a blade coating method, a roll coating method, a spray coating method, a capillary coating method, an inkjet method, a screen printing method, a gravure printing method, a flexographic printing method, and the like can be used. Incidentally, in the case of forming a film on the surface of the anode, it is preferable to perform a treatment with a ultraviolet ray plus ozone, oxygen plasma, argon plasma, or the like before film formation to remove impurities on the anode and adjust the ionization potential, thereby enhancing the hole injection performance.

Next, the second electrode 4 is formed on the organic functional layer 3. As the method of forming the second electrode 4, a sputtering method, a vacuum deposition method, or the like can be used.

### [Back Surface Member Formation Step]

The back surface member formation step is a step of forming the sealing layer 5 on the protective layer 7 (the sealing layer 5 and the moisture absorbing layer 6 on the protective layer 7 in the case where the moisture absorbing layer 6 is formed), and it is possible to adopt various methods but, for example, the step can be carried out by the following method. Incidentally, in the present embodiment, the moisture absorbing layer 6 is formed on the protective layer 7 and the sealing layer 5 is formed thereon but, depending on the desired structure, the sealing layer 5 may be formed on the protective layer 7 and the moisture absorbing layer 6 may be formed thereon.

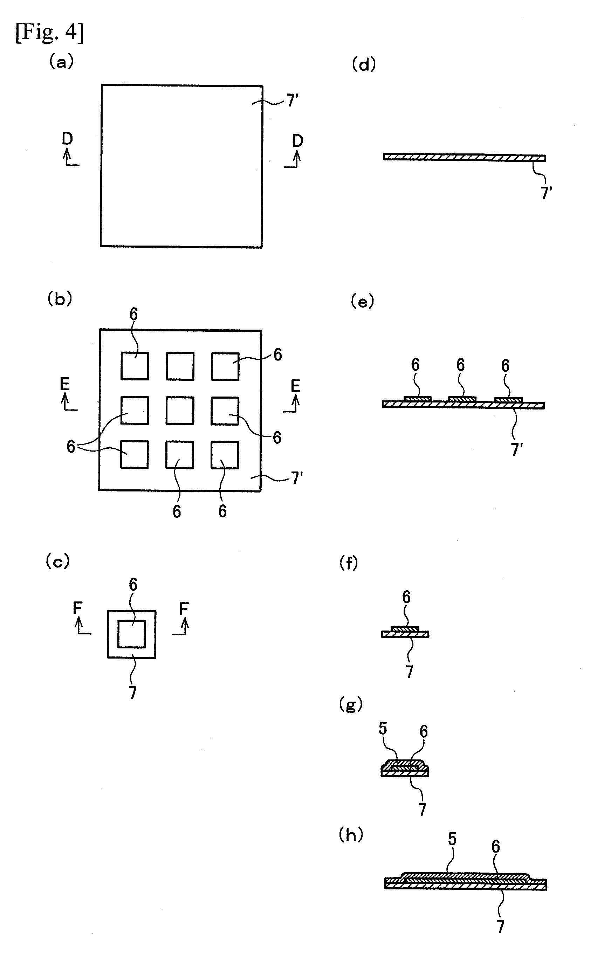

The (a) of Fig. 4 to (h) of Fig. 4 are schematic views showing the production steps of the back surface member of the organic EL luminescent device. Incidentally, the (d) of Fig. 4, (e) of Fig. 4, and (f) of Fig. 4 are cross-sectional views at D-D, E-E, and F-F in the (a) of Fig. 4, (b) of Fig. 4, and (c) of Fig. 4, respectively. Moreover, the (h) of Fig. 4 is an enlarged view of the (g) of Fig. 4.

First, a flexible film or foil 7' or the like is prepared, which is to be a protective layer 7 as shown in the (a) of Fig. 4 and (d) of Fig. 4. Then, as sown in the (b) of Fig. 4 and (e) of Fig. 4, the moisture absorbing layer 6 is formed on the surface of the film or foil 7' and thereafter, the sealing layer 5 is formed.

### <Formation Method of Moisture Absorbing Layer>

As a formation method in the case of forming the moisture absorbing layer 6, it is possible to appropriately select the method depending on materials. For example, dry film-forming methods such as a vacuum deposition method; wet film-forming methods such as a spin coating method, a dip coating method, a die coating method, a bar coating method, a blade coating method, a roll coating method, a spray coating method, a capillary coating method, an inkjet method, a screen printing method, a gravure printing method, a flexographic printing method, and an application method with a dispenser can be used. Of these, from the standpoints of freedom of a printing pattern and cost reduction, the wet film-forming method is preferred, the printing methods such as a die coating method, a spray coating method, a screen printing method, a gravure printing method, a flexographic printing method, and an application method with a dispenser are more preferred, and a screen printing method and dispenser application are particularly preferably adopted. In the case of using the wet film-forming method, in order to remove the solvent used for the film formation, it is preferred to perform drying after the film formation. The atmosphere at drying is not particularly limited unless the performance of the moisture absorbing layer 6 is not largely impaired but is preferably an atmosphere in which moisture and oxygen hardly have an influence, so that an argon or nitrogen atmosphere is preferred. Moreover, from the standpoint of removing the solvent, drying is preferably performed at 100°C or more and, from the standpoint of hardly deteriorating the flexible film or foil 7', drying is preferably performed at 300°C or less.

Then, as shown in the (c) of Fig. 4 and (f) of Fig. 4, the flexible film or foil 7' is cut along the outer periphery of the moisture absorbing layer 6 while a certain distance is kept. Incidentally, the cutting may be performed after the subsequent step of forming the sealing layer.

### <Formation Method of Sealing Layer>

Next, as shown in the (g) of Fig. 4 and the (h) of Fig. 4, the sealing layer 5 containing the thermoplastic resin is fabricated on the moisture absorbing layer 6. In this case, the sealing layer 5 is fabricated so that the whole surface of the moisture absorbing layer 6 is covered with the sealing layer 5 and the edge part of the sealing layer 5 is protruded from the edge part of the moisture absorbing layer 6.

As the fabrication method of the sealing layer 5, methods of coating methods, printing methods, and the like such as roll coating, spin coating, a screen printing method, and spray coating may be used but, from the standpoint of workability, a method of pasting a sheet-shape thermoplastic resin on the surface of the flexible film or foil 7' is preferably adopted. As a method of attaching the sheet-shape thermoplastic resin on the surface of the flexible film or foil 7', for example, there is preferably adopted a method in which the flexible film or foil 7' and the sheet-shape thermoplastic resin are brought into contact with each other and are opposed each other and heat and pressure are imparted to press-fix them under heating. The heating method and the press-fixing method in this case are not particularly limited but there are preferably adopted a method of pressurization by a pressing apparatus or the like on a hot plate in a state that the flexible film or foil 7' and the sheet-shape thermoplastic resin are brought into contact with each other and are opposed each other, a method of pressurization by a pressing apparatus or the like in a high-temperature atmosphere such as an oven or a heating furnace, or a method of thermal press-fixing by a heating roller, and the like.

### [Lamination Method of Spacer Resin Layer]

The spacer resin layer 9 may be disposed on the second electrode 4 of the organic EL element or may be disposed on the sealing layer 5 of the back surface member. In the case of disposing the spacer resin layer 9 on the sealing layer 5 of the back surface member, for example, a film to be the spacer resin layer 9 is laminated to the sealing layer 5. In order to enhance adhesiveness of the spacer resin layer 9 and the sealing layer 5, it is preferred to press-fix them with a urethane roller or the like and it is also preferred to perform press-fixing under heating. The heating temperature is preferably a temperature similar to or lower than the temperature in the heating treatment step of the organic EL element and the back surface member, which will be mentioned later. The environment is preferably an atmosphere in which moisture and oxygen hardly have an influence, and an argon or nitrogen atmosphere is preferred.

### [Heating Treatment Step]

Then, the sealing layer 5-formed surface of the back surface member is opposed and overlaid to the second electrode 4-formed surface side of the organic EL element obtained in the above step so as to sandwich the spacer resin layer 9, followed by a heating treatment. By the heating treatment, the sealing layer 5 is formed so as to cover the first electrode 2, the organic functional layer 3, and the second electrode 4.

As the heating treatment method, a heat laminator, an oven, a hot plate, or the like can be used. Incidentally, the heating treatment temperature varies depending on the kind of the thermoplastic resin but is usually from 70 to 130°C. The heating temperature is preferably high in view of high adhesiveness of the sealing layer 5 and the organic EL element but, on the other hand, is preferably low in view of hardly causing crystallization and the like of the organic functional layer 3 of the organic EL element.

### [Repair Step]

After the heat treatment, the short-circuited spot is repaired. As the repair method, conventionally known laser repair methods such as the aforementioned method described in Patent Document 3 can be used.

As above, the organic EL luminescent device of the invention can be produced. The organic EL luminescent device of the invention can be applied to display parts of personal computers, mobile phones, digital still cameras, television sets, view finder-type or monitor-direct-viewing video tape recorders, car navigation devices, pagers, electronic notebooks, electronic calculators, word processors, work stations, TV phones, POS terminals, devices fitted with a touch panel, and the like.

### Examples

The following will further specifically describe the invention with reference to Examples. However, the invention is not limited to the following Examples and the invention can be performed with arbitrarily changing it unless it departs from the gist thereof.

### [Example 1]

An organic EL luminescent device was produced by the following method.

First, an organic EL element having a luminescent region 7 mm square having the structure shown in the (a) of Fig. 2 and the (b) of Fig. 2 was fabricated.

### <Formation of Hole Injection Layer on ITO Substrate]

As a substrate, there was used one in which an indium-tin oxide (ITO) transparent electroconductive film (first electrode 2) having a film thickness of 70 nm on a glass substrate.

Then, a polymer compound having a repeating unit represented by the following formula (A) (PB1, weight-average molecular weight: 52,000, number-average molecular weight: 32,500) and 4-isopropyl-4'-methyldiphenyliodonium tetraquis(pentafluorophenyl) borate were mixed in a mass ratio of 100:20, and there was prepared a composition in which the mixture was dissolved in ethyl benzoate so that the total concentration of the mixture was 2.0% by mass. The composition was applied on the above substrate by spin coating at 1500 rpm for 30 seconds in an atmosphere of the air. Thereafter, the whole was heated at 230°C for 15 minutes to thereby form a hole injection layer having a film thickness of 30 nm.

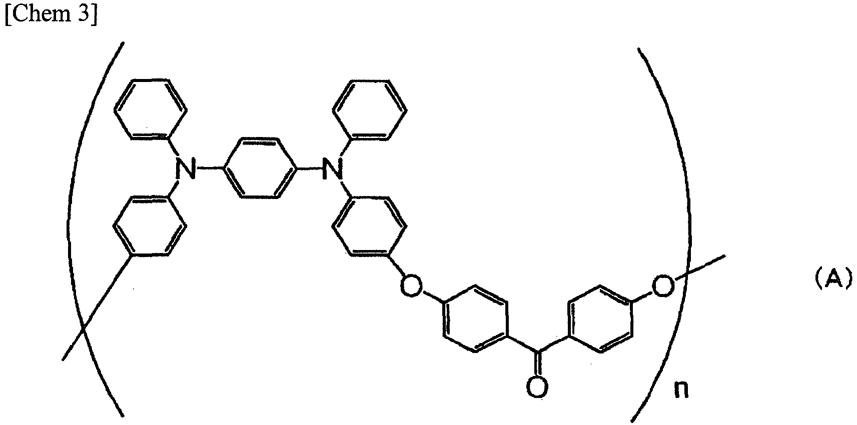

### <Formation of Hole Transport Layer>

Then, as a hole transport layer, a film of 4,4'-bis[N-(9-phenanthlyl)-N-phenyl-amino]biphenyl (PPD) shown in the following formula (B) was formed by a vacuum deposition method so as to have a film thickness of 45 nm.

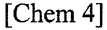

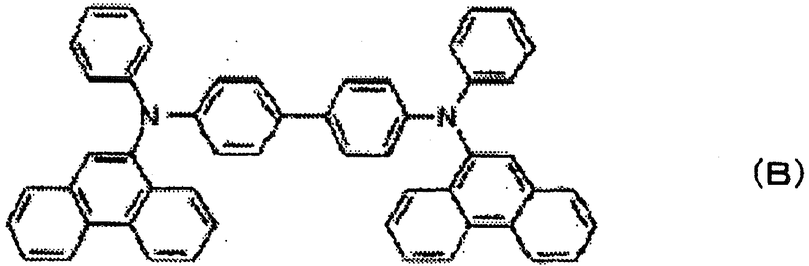

### <Formation of Luminescent Layer>

Then, as a luminescent layer, a film of tris(8-hydroxyquinolinato)aluminum (Alq3) was formed by a vacuum deposition method so as to have a film thickness of 60 nm.

### <Formation of Electron Injection Layer]

Thereafter, lithium fluoride (LiF) was deposited on the luminescent layer by a vacuum deposition method so as to have a film thickness of 0.5 nm to form an electron injection layer. Here, from the hole injection layer to the electron injection layer were regarded as an organic functional layer 3.

### <Formation of Cathode>

Then, aluminum was deposited by a vacuum deposition method so as to have a film thickness of 80 nm to form a second electrode 4.

Thereafter, a back surface member was produced by the procedures shown in the (a) of Fig. 4 to (h) of Fig. 4.

### <Formation of Moisture Absorbing Layer>

An aluminum foil 7' having a thickness of 95 µm was cut into a piece 100 mm square, as shown in the (a) of Fig. 4 and (d) of Fig. 4. Using DryPaste-S1 (manufactured by Saes Getters) containing calcium oxide as a main agent as a desiccant, a square-shape moisture absorbing layer 6 having a thickness of 30 µm and a side of 18 mm was formed on the cut aluminum foil 7' by a screen printing machine in an atmosphere of the air with arranging three layers by three layers lengthwise and crosswise, respectively, as shown in the (b) of Fig. 4 and (e) of Fig. 4. After printing, the product was immediately transferred under a nitrogen atmosphere and was heated on a hot plate at 200°C for 30 minutes. As shown in the (c) of Fig. 4 and (f) of Fig. 4, the aluminum foil 7' was cut into pieces 22 mm square so that each moisture absorbing layer 6 came a center.

### <Fabrication of Sealing Layer>

A sheet having a thickness of 50 µm, in which a thermoplastic resin obtained by mixing polyisobutylene and cyclopentadiene-dicyclopentadiene copolymer in a mass ratio of 28:72 was sandwiched with two sheets of a PET film, was cut into a piece 22 mm square. Thereafter, one PET film was peeled off and, as shown in the (g) of Fig. 4 and (h) of Fig. 4, it was overlaid on the sheet with the PET film-peeled side being downward so that the whole surface of the moisture absorbing layer 6 is covered and the both edges are protruded by 2 mm from the edge part of the moisture absorbing layer 6 in a horizontal direction (so that the sheet and the protective layer (aluminum foil) 7 are overlaid when viewed from above). In order to adhere them closely so that air did not enter between the protective layer 7 and moisture absorbing layer 6 and the sheet, the sheet was press-fixed with a roller on a hot plate at 100°C.

### <Formation of Spacer Resin Layer>

With regard to the back surface member fabricated until the aforementioned sealing layer, another PET film of the sheet was peeled off and a PET film (manufactured by Mitsubishi Plastics, Inc., melting point: 260°C) having a thickness of 38 µm cut into a piece 18 mm square was overlaid thereon so as to be positioned at a center of the sheet (so that the PET film and the moisture absorbing layer 6 were overlaid when viewed from above) to form a spacer resin layer 9'.

### <Pasting of Organic EL Element and Sealing Member>

On the spacer resin layer 9', an organic EL element was overlaid with the second electrode being downward. Here, the spacer resin layer 9' (PET film) was placed so as to be protruded by 1 mm each from the luminescent region edge part 3a of the luminescent layer of the organic EL element (Fig. 2). Then, with the glass substrate as the translucent substrate 1 being downward, it was placed on a hot plate at 110°C and the aluminum foil 7' was press-fixed with a roller to produce an organic EL luminescent device 10'. Moreover, it was confirmed that the whole luminescent region of the organic EL luminescent device 10' emitted a light. Incidentally, here, the heating treatment temperature at the formation of the sealing layer 5 is 110°C.

### <Laser Repair>

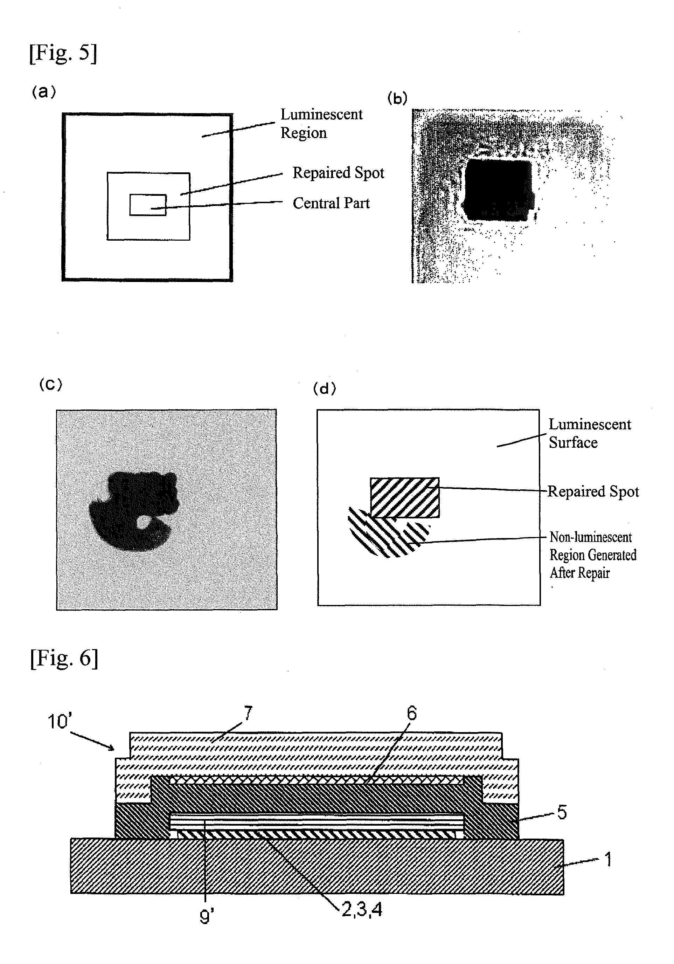

Laser repair was performed by irradiating the organic EL luminescent device 10' with a laser light (Nd:YAG, wavelength 532 nm, output: 0.4 mJ) having passed through a slit 25 µm square from the glass substrate (translucent substrate 1) side. The shape of the repaired spot was a rectangle having a size of 60 µm x 35 µm as shown in the (a) of Fig. 5, and the central part of the (a) of Fig. 5 is a spot where a luminescent defect was present and the repair spot in the (a) of Fig. 5 is a spot irradiated with the laser light. After the laser repair was completed, it was visually confirmed that no abnormality in luminescence was present around the repaired spot and the repaired spot did not emit a light.

### <Confirmation of Adhesive strength>

Into the organic EL luminescent device 10' of Example 1, at the edge part, a tip of tweezers was inserted between the sealing layer and the glass substrate to lift up a part of the sealing layer. The part of the sealing layer lifted up was grasped with a hand and the sealing layer was peeled from the glass substrate. After peeling-off, when the glass substrate and the sealing layer were observed, it was confirmed that the cathode was not present on the sealing layer side and remained on the glass substrate side.

### [Example 2]

### <Formation of Hole Injection Layer onto ITO substrate>

As a translucent substrate 1, there was used one in which stripe-shape indium-tin oxide (ITO) transparent electroconductive film (first electrode 2) having a film thickness of 70 nm and a bank are alternately formed within a central part 73 mm square on a glass substrate 100 mm square.

### <Formation of Hole Injection Layer>

Then, a polymer compound PB-2 having a repeating unit represented by the following formula (C), a polymer compound PB-3 having a repeating unit represented by the following formula (D), and 4-isopropyl-4'-methyldiphenyliodonium tetraquis(pentafluorophenyl) borate were mixed in a mass ratio of 75:25:15 and there was prepared a composition in which the mixture was dissolved in ethyl benzoate so that the concentration of the mixture was 0.8% by mass. The composition was applied on ITO of the above substrate using an inkjet apparatus in an atmosphere of the air, followed by vacuum drying. Thereafter, the whole was heated at 230°C for 1 hour to thereby form a hole injection layer having a film thickness of 35 nm.

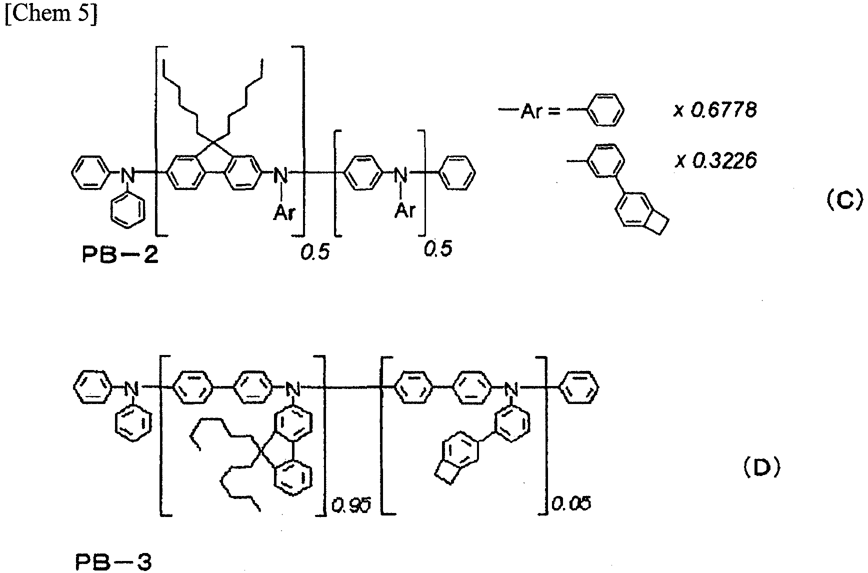

### <Formation of Hole Transport Layer, Luminescent Layer, Electron Injection Layer, and Cathode>

Each of these layers is formed in the same manner as in Example 1.

Then, a back surface member was produced.

### <Formation of Moisture Absorbing Layer>

An aluminum foil (protective layer 7) having a thickness of 100 µm was cut into a piece 100 mm square. Using DryPaste-S1 (manufactured by Saes Getters) containing calcium oxide as a main agent as a desiccant, a moisture absorbing layer 6 having a thickness of 30 µm and a size of 78 mm×80 mm was formed on a central part of the cut aluminum foil by a screen printing machine in an atmosphere of the air. After printing, the product was immediately transferred under a nitrogen atmosphere and was heated on a hot plate at 200°C for 30 minutes.

### <Fabrication of Sealing Layer>

The same operations as in Example 1 were conducted except that one obtained by cutting the thermoplastic resin into a size of 82 mm×84 mm was used in Example 1.

### <Formation of Spacer Resin Layer>

With regard to the back surface member fabricated until the sealing layer, another PET film of the sheet was peeled off and a PET film (manufactured by Mitsubishi Plastics, Inc., melting point: 260°C) having a thickness of 38 µm formed into a " 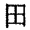 "-shape (outer size: 78 mm×80 mm, PET width: 2 mm) as shown in the (b) of Fig. 1 was overlaid thereon so as to be positioned at a center of the sheet (so that the outer periphery part of the PET film and the outer periphery part of the moisture absorbing layer 6 were overlaid when viewed from above) to form a spacer resin layer 9.

### <Pasting of Organic EL Element and Sealing Member>

On the spacer resin layer 9, the organic EL element was overlaid with the second electrode 4 being downward so that the sealing member covered the whole luminescent region of the organic EL element and the center of the sealing member was coincident with the center of the luminescent region of the organic EL element. With the glass substrate (translucent substrate 1) being downward, it was placed on a hot plate at 110°C and the aluminum foil (protective layer 7) was press-fixed with a roller to produce an organic EL luminescent device 10 having the structure shown in the (a) of Fig. 1. Moreover, it was confirmed that the whole luminescent region of the organic EL luminescent device 10 emitted a light. Incidentally, here, the heating treatment temperature at the formation of the sealing layer 5 is 110°C.

### <Laser Repair>

The same operations as in Example 1 were conducted for the organic EL luminescent device 10. After the laser repair was completed, it was visually confirmed that no abnormality in luminescence was present around the repaired spot and a central part of the repaired spot where abnormal luminescent had been observed did not emitted a light. Thus, it was confirmed that laser repair was normally performed and abnormality was absent in the luminescence around the repaired spot by the laser repair.

### [Example 3]

### <Fabrication of Organic EL Luminescent Device>

The same operations were conducted in Example 2 except that three sheets of a PET film (manufactured by Mitsubishi Plastics, Inc., melting point: 260°C) having a thickness of 25 µm and having a "strip-shape" (a shape having 15 mm×73 mm, v, x and z are each 15 mm and w and y are each 14 mm in the (a) of Fig. 3) were arranged at intervals of 14 mm from the edge part of the luminescent part, thereby fabricating an organic EL luminescent device.

### <Laser Repair>

The same operations as in Example 1 were conducted for the organic EL luminescent device. After the laser repair was completed, as shown in the (b) of Fig. 5, it was visually confirmed that no abnormality in luminescence was present around the repaired spot and a central part of the repaired spot did not emitted a light. Thus, it was confirmed that laser repair was normally performed and abnormality was absent in the luminescence around the repaired spot by the laser repair. Incidentally, the second electrode remained at the central part of the repaired spot but did not emit any light.

### [Comparative Example 1]

### <Fabrication of Organic EL Element>

An organic EL luminescent device was produced in the same manner as in Example 1 except that the spacer resin layer was not formed.

### <Laser Repair>

Laser repair was conducted by the same operations as in Example 1 for the organic EL luminescent device. Visually, an arc-shape non-luminescent region was observed at an outer edge part of the laser-repaired spot, and abnormal luminescence caused by the laser repair was observed.

### <Confirmation of Adhesive strength>

For the organic EL luminescent device of Comparative Example 1, the sealing layer was peeled from the glass substrate by the same operations as in Example 1. After peeling-off, when the glass substrate and the sealing layer were observed, it was confirmed that the sealing layer was peeled off while the cathode was adhered on the sealing layer side.

### [Comparative Example 2]

### <Fabrication of Organic EL Element>

An organic EL luminescent device was produced in the same manner as in Example 2 except that the spacer resin layer was not formed.

### <Laser Repair>

Laser repair was conducted by the same operations as in Example 1 for the organic EL luminescent device. Visually, as shown in the (c) of Fig. 5 and (d) of Fig. 5, an arc-shape non-luminescent part was observed at an outer edge part of the laser-repaired spot, and abnormal luminescence caused by the laser repair was observed.

While the invention has been described in detail and with reference to specific embodiments thereof, it will be apparent to one skilled in the art that various changes and modifications can be made therein without departing from the spirit and scope thereof. The present application is based on Japanese Patent Application No. 2012-107847 filed on May 9, 2012, and the contents are incorporated herein by reference.

### Description of Reference Numerals and Signs

- 1: Translucent substrate
- 2: First electrode
- 3: Organic functional layer
- 4: Second electrode
- 5: Sealing layer
- 6: Moisture absorbing layer
- 7: Protective layer
- 9, 9', 9A, 9B, 9C, 9D, 9E, 9F, 9G, 9H: Spacer resin layers
- 9a: Frame part
- 9b: Transverse part

## Claims

1. An organic EL luminescent device comprising:
a translucent substrate,
a first electrode formed on the translucent substrate,
an organic functional layer that is formed on the first electrode and has at least a luminescent layer,
a second electrode formed on the organic functional layer,
a sealing layer containing a thermoplastic resin, the layer being formed so as to cover at least the first electrode, the second electrode and the organic functional layer, and
a protective layer formed on the sealing layer,
wherein a spacer resin layer intervenes in at least a part of the space between the second electrode and the sealing layer and an adhesive strength at the interface between the space resin layer and the second electrode is lowest among adhesive strengths at all interfaces present between the sealing layer and the translucent substrate.

2. The organic EL luminescent device according to claim 1, wherein the spacer resin layer and the second electrode are not adhered.

3. The organic EL luminescent device according to claim 1 or 2, wherein the sealing layer is formed by a heating treatment of the thermoplastic resin and the melting point of the spacer resin layer is a temperature for the heating treatment or more.

4. The organic EL luminescent device according to any one of claims 1 to 3, wherein the spacer resin layer intervenes in the whole space between the second electrode and the sealing layer.
